# EUROPEAN PATENT SPECIFICATION

(11) **EP 4 120 813 B1**
(45) Date of publication and mention of the grant of the patent: **27.05.2026**
(21) Application number: 20924838.4
(22) Date of filing: 10.03.2020
(51) Int. Cl.: H05K 13/02, H05K 13/08, H05K 13/04

(54) **TAPE GUIDE MANAGEMENT SYSTEM**
BANDFÜHRUNGSVERWALTUNGSSYSTEM
SYSTÈME DE GESTION DE GUIDE DE BANDE

(43) Date of publication of application: 18.01.2023
(73) Proprietor: Fuji Corporation, Chiryu-shi, Aichi 472-8686 (JP)
(72) Inventor: IWASAKI, Masataka, Chiryu-shi, Aichi 472-8686 (JP)
(74) Representative: Grünecker Patent- und Rechtsanwälte PartG mbB
(86) International application number: PCT/JP2020/010329
(87) International publication number: WO 2021/181522

(56) References cited:
- EP-A1- 1 796 453
- EP-A1- 3 041 337
- WO-A1-2015/029124
- WO-A1-2017/109892
- WO-A1-2017/109892
- JP-A- 2002 533 944
- JP-A- 2004 165 603
- JP-A- 2006 108 322
- JP-A- 2015 185 633
- JP-A- 2015 185 634
- US-A1- 2004 149 383

## Description

### Technical Field

The present disclosure relates to a tape guide management system.

### Background Art

A system for acquiring an identification code attached to a tape guide is known (refer to, for example, Patent Literature 1). The tape guide is mounted on a tape feeder that feeds a carrier tape in which components are housed. The tape guide includes a component exposing section that exposes a component from a carrier tape fed by a tape feeder. The component exposing section is, for example, a cutter member that peels off a cover tape of the carrier tape from a base tape at a distal end portion.

Multiple types of tape guides are provided according to a type of a carrier tape and a type of a component. That is, the component exposing section is formed in a shape corresponding to the type of the carrier tape and the type of the component. An identification code attached to the tape guide is set according to the type of the tape guide. The identification code is, for example, a two-row code and corresponds to three types of "white-white", "white-black", and "black-white".

In the above-described system, when an identification code is read, comparison and collation between the identification code and a serial ID of a tape feeder is performed. Then, when the collation does not match each other, it is determined that a tape guide mounted on a tape feeder does not correspond to a carrier tape fed by the tape feeder, a warning is issued to an operator, the tape guide is prompted to be exchanged. Patent literature 2)-5) is referring to further relevant prior art describing tape feeding arrangements.

### Patent Literature

Patent Literature 1: WO2013/157107;
Patent Literature 2: WO2017/109892;
Patent Literature 3: EP3041337;
Patent Literature 4: US2004/149383;
Patent Literature 5: EP1796453.

### Summary of the Invention

### Technical Problem

Incidentally, because a tape guide is in contact with a carrier tape at a component exposing section to expose a component from the carrier tape, the tape guide is a consumable article that is susceptible to a change in shape or the like due to contact with the carrier tape. Accordingly, when a use period of a tape guide is extended or the number of tape peeling increases, a component exposure process of the tape guide may be affected by a temporal change in shape or the like of a component exposing section. However, in the above-described system, collation with a tape feeder is merely performed according to a type of a tape guide, management of each tape guide is not performed.

An object of the present specification is to provide a tape guide management system capable of individually managing a tape guide.

### Solution to Problem

The present specification discloses a tape guide management system for managing a tape guide that is mounted on a tape feeder feeding a carrier tape in which a component is housed and is able to expose the component from the carrier tape, which includes a tag provided in each tape guide and configured to indicate individual identification information, a tag reader configured to read the individual identification information from the tag, a storage section configured to store the individual identification information and management information of the tape guide in association with each other, and a management device configured to manage the tape guide based on the management information corresponding to the individual identification information read by the tag reader, wherein a use history includes the number of exposure processes that an exposure process of exposing the component from the carrier tape is performed by the tape guide, and a rate of success and failure of the exposure process, wherein the management device includes a success/failure totalizing section configured to totalize the rate of success and failure for each type of the tape guide, and a second guide control section configured to perform a second guide indicating a matching rate of the carrier tape or the tape feeder for each type of the tape guide to an operator based on the rate of success and failure totalized by the success/ failure totalizing section.

According to the present disclosure, it is possible to manage individual use of a tape guide mounted on a tape feeder.

### Brief Description of Drawings

[Fig. 1] Fig. 1 is a configuration diagram of a tape guide management system according to an embodiment.
[Fig. 2] Fig. 2 is a plan view of a component mounter.
[Fig. 3] Fig. 3 is a top view of a carrier tape.
[Fig. 4] Fig. 4 is a cross-sectional view of the carrier tape taken along line IV-IV illustrated in Fig. 3.
[Fig. 5] Fig. 5 is a side view of a tape feeder to be mounted on the component mounter.
[Fig. 6] Fig. 6 is a perspective view of a tape guide to be mounted on the tape feeder.
[Fig. 7] Fig. 7 is a diagram illustrating an example of a relationship between individual identification information and management information of a tape guide stored in a storage section.
[Fig. 8] Fig. 8 is a flowchart of an example of a control routine executed for collation using individual identification information of a tape guide.
[Fig. 9] Fig. 9 is a flowchart of an example of a control routine executed for updating a use history using individual identification information of a tape guide.
[Fig. 10] Fig. 10 is a flowchart of an example of a control routine executed to guide inspection or exchange using individual identification information of a tape guide.
[Fig. 11] Fig. 11 is a flowchart of an example of a control routine executed to implement limitable use by using individual identification information of a tape guide.
[Fig. 12] Fig. 12 is a flowchart of an example of a control routine executed to guide a matching rate between a type of a tape guide and a type of a carrier tape or a type of a tape feeder using individual identification information of the tape guide.
[Fig. 13] Fig. 13 is a configuration diagram of a tape guide management system according to a modification embodiment.

### Description of Embodiments

### 1. Schematic Configuration of Tape Guide Management System

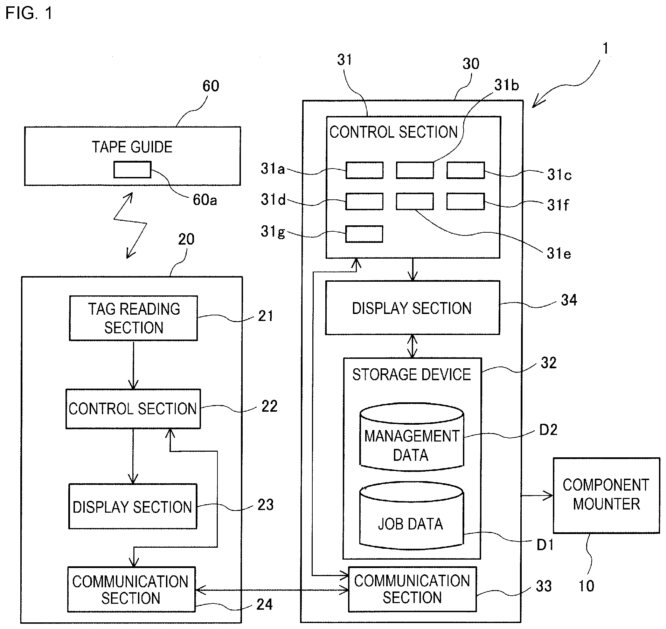

Tape guide management system 1 of the present embodiment is a system for managing a tape guide mounted on a tape feeder that feeds a carrier tape in which components are housed. As illustrated in Fig. 1, tape guide management system 1 includes component mounter 10, tag reader 20, and host computer 30. Component mounter 10 and host computer 30 are communicatively connected to each other. Also, tag reader 20 and host computer 30 are communicatively connected to each other.

### 2. Schematic Configuration of Component Mounter

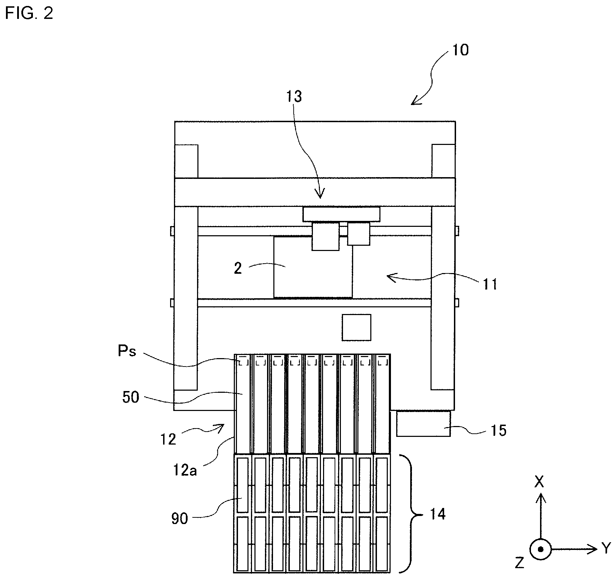

Component mounter 10 is a device for mounting a component on a board. As illustrated in Fig. 2, component mounter 10 includes board conveyance section 11, component supply section 12, component transfer section 13, reel holding section 14, and control section 15. Hereafter, a horizontal conveyance direction (an up-down direction in Fig. 2) in which a component is fed is defined as an X-axis direction, a horizontal conveyance direction (a left-right direction in Fig. 2) in which a board is conveyed and which is orthogonal to the X-axis direction is defined as a Y-axis direction, and a direction (a top-bottom direction of a paper surface in Fig. 2) orthogonal to the X-axis direction and the Y-axis direction is defined as a Z-axis direction.

Board conveyance section 11 is a belt conveyor or the like that sequentially conveys board 2 in the Y-axis direction. Component supply section 12 supplies component 3 such as an electronic component to be mounted on board 2 to component transfer position Ps to be described below. Component supply section 12 includes tape feeder 50 to be described below in detail and multiple slots 12a on which tape feeder 50 is detachably mounted. Slots 12a are arranged side by side in the Y-axis direction. Slot numbers for identifying each other are set to each of slots 12a. Component supply section 12 uses tape feeder 50 to feed and move carrier tape 80 wound on reel 90 in the X-axis direction and conveys component 3 housed in carrier tape 80 to component transfer position Ps located on a distal end side of tape feeder 50.

Component transfer section 13 includes mounting head 13a on which a suction nozzle (not illustrated) is detachably mounted. Mounting head 13a is movable in the X-axis direction and the Y-axis direction and is also movable up and down in the Z-axis direction. Component 3 is picked up by a suction nozzle by using a negative pressure or the like. Mounting head 13a picks up component 3 supplied to component transfer position Ps by the suction nozzle, then moves component 3 to board 2 positioned at a predetermined mounting position by board conveyance section 11, releases pickup of the component made by the suction nozzle, and attaches component 3 to board 2.

Reel holding section 14 exchangeably holds reel 90 on which carrier tape 80 is wound. It should be noted that Reel holding section 14 may be capable of arranging two reels 90 in the X-axis direction which is a feeding direction of carrier tape 80.

Control section 15 controls an operation of component mounter 10 (specifically, board conveyance section 11, component supply section 12, and component transfer section 13). Control section 15 includes a CPU and a memory and performs various types of control processing according to a previously determined program.

### 3. Configuration of Carrier Tape and Reel

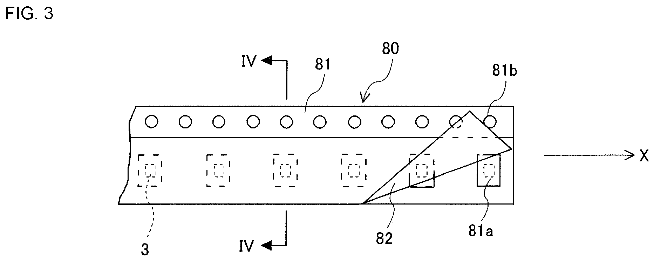

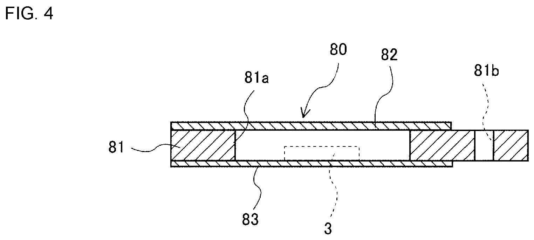

Carrier tape 80 is a tape that houses component 3. Multiple types of carrier tapes 80 are prepared according to a size and a shape of component 3. As illustrated in Figs. 3 and 4, carrier tape 80 is configured with base tape 81, cover tape 82, and bottom tape 83.

Base tape 81 is a tape serving as a base of carrier tape 80. Base tape 81 is provided with component housing section 81a and feed holes 81b. Component housing section 81a is a portion in which a space for housing component 3 is formed. Component housing section 81a is provided at a center portion in a tape width direction of base tape 81. Component housing section 81a is provided at a predetermined pitch interval in a longitudinal direction of the tape. Feed holes 81b are through-holes for feeding carrier tape 80 in the X-axis direction. Feed holes 81b are provided at an end portion of the base tape in the tape width direction. Feed holes 81b are provided at a predetermined pitch interval in the longitudinal direction of the tape.

Cover tape 82 is a tape that closes an opening of component housing section 81a of base tape 81. Cover tape 82 is bonded to upper surfaces of both end portions of base tape 81 in the tape width direction by an adhesive. Bottom tape 83 is a tape for preventing component 3 housed in component housing section 81a from falling therefrom. Bottom tape 83 is bonded to a lower surface of base tape 81 by an adhesive.

Reel 90 is a disk-shaped member around which carrier tape 80 is wound. **It** should be noted that multiple types of reels 90 may be prepared according to a size, a shape, or the like of carrier tape 80. Reel 90 is exchangeably and rotatably held by Reel holding section 14. Reel 90 is rotatably held by Reel holding section 14. Tape feeder 50 can pull carrier tape 80 from reel 90 held by reel holding section 14 in a state of being mounted on slot 12a.

### 4. Configuration of Tape Feeder

Tape feeder 50 is a device for feeding carrier tape 80 in the X-axis direction to supply component 3 to component transfer position Ps. Multiple types of tape feeders 50 are prepared according to a size and a shape of carrier tape 80. Tape feeder 50 is mounted on slot 12a of component supply section 12. Tape feeder 50 is an autoloading feeder capable of feeding carrier tape 80 of which tape end is inserted into an insertion section to component transfer position Ps by a feeding section.

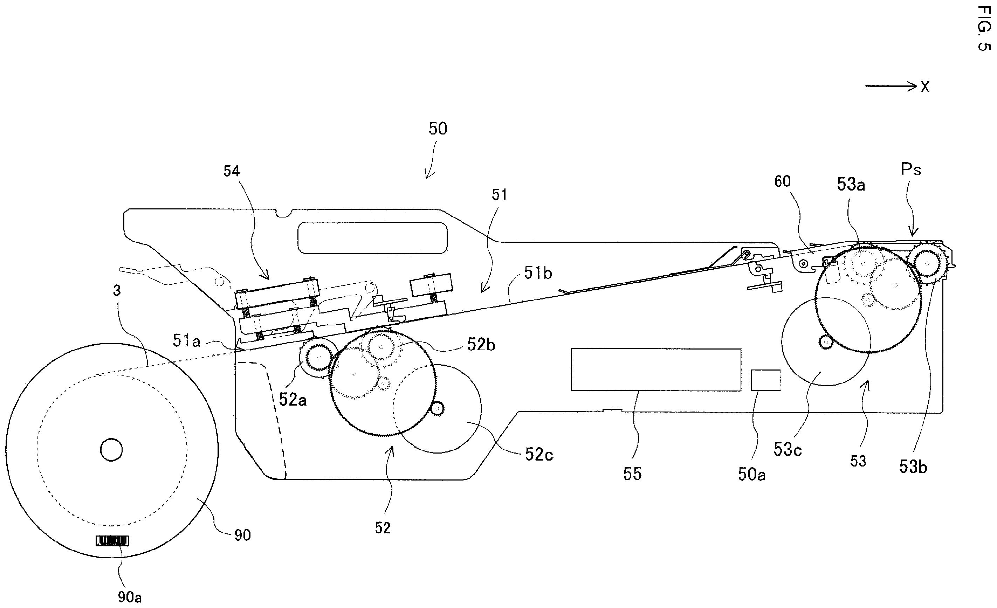

As illustrated in Fig. 5, tape feeder 50 includes feeder main body 51, first feeding section 52, second feeding section 53, tape pressing section 54, tape guide 60, and control section 55.

Feeder main body 51 is formed in a flat box shape. Feeder main body 51 includes insertion section 51a and conveyance path 51b. Insertion section 51a is a portion into which a tape end of carrier tape 80 that is a conveyance target is inserted. Conveyance path 51b is a rail that supports carrier tape 80 of which tape end is inserted into insertion section 51a from a lower side. Carrier tape 80 of which tape end is inserted into insertion section 51a is pressed against an upper surface of conveyance path 51b by tape pressing section 54.

First feeding section 52 feeds carrier tape 80 of which tape end is inserted into insertion section 51a in the X-axis direction along conveyance path 51b to a position closed to component transfer position Ps. First feeding section 52 includes a pair of sprockets 52a and 52b and motor 52c.

Each of sprockets 52a and 52b is a rotary member having teeth that engage with feed holes 81b of carrier tape 80. Each of sprockets 52a and 52b is rotatably supported by feeder main body 51. The pair of sprockets 52a and 52b are disposed to be separated from each other in the Y-axis direction which is a tape conveyance direction. Each of sprockets 52a and 52b is disposed below conveyance path 51b such that teeth thereof slightly protrude upward from an upper surface of conveyance path 51b.

Motor 52c is a stepping motor that rotates sprockets 52a and 52b. Motor 52c is coupled to each of sprockets 52a and 52b through a decelerator. Motor 52c rotates sprockets 52a and 52b by a pitch interval of component housing section 81a of carrier tape 80 to feed carrier tape 80 in the X-axis direction. When motor 52c is driven in a state where the teeth of sprockets 52a and 52b are engaged with feed holes 81b of carrier tape 80 having a tape end inserted into insertion section 51a, carrier tape 80 is fed to a position close to component transfer position Ps in the X-axis direction.

In a state where carrier tape 80 fed to a position close to component transfer position Ps is restricted from moving upward and in a tape width direction by tape guide 60, second feeding section 53 further feeds carrier tape 80 in X-axis direction to pull carrier tape 80 to component transfer position Ps. Second feeding section 53 includes a pair of sprockets 53a and 53b and motor 53c.

Each of sprockets 53a and 53b has teeth that engage with feed holes 81b of carrier tape 80. Each of sprockets 53a and 53b is rotatably supported by feeder main body 51. The pair of sprockets 53a and 53b are disposed to be separated from each other in the Y-axis direction which is a tape conveyance direction. Each of sprockets 53a and 53b is disposed below a conveyance surface of tape guide 60 such that teeth thereof slightly protrude upward from the conveyance surface thereof.

Motor 53c is a stepping motor that rotates sprockets 53a and 53b. Motor 53c is coupled to each of sprockets 53a and 53b through a decelerator. Motor 53c rotates sprockets 53a and 53b by a pitch interval of component housing section 81a of carrier tape 80 to feed carrier tape 80 in the X-axis direction. When motor 53c is driven in a state where teeth of sprockets 53a and 53b are engaged with feed holes 81b of carrier tape 80 having tape end reached a position close to component transfer position Ps, carrier tape 80 thereof is pulled to component transfer position Ps in the X-axis direction.

### 5. Configuration of Tape Guide

Tape guide 60 is a member that supplies component 3 in carrier tape 80 thereof to component transfer position Ps while guiding carrier tape 80 conveyed on conveyance path 51b. Tape guide 60 is mounted on tape feeder 50 and is detachable from tape feeder 50. Multiple types of tape guides 60 are prepared to correspond to a size and a shape of carrier tape 80.

Tape guide 60 is disposed on an X-axis direction downstream side of conveyance path 51b. Tape guide 60 can press an upper surface of carrier tape 80 and expose component 3 from component housing section 81a of base tape 81 of carrier tape 80. Tape guide 60 is energized and pressed downward feeder main body 51 and presses an upper surface of carrier tape 80 even when a tape thickness of carrier tape 80 is changed, and thus, carrier tape 80 can be prevented from floating up, and sprockets 53a and 53b can be reliably engaged with feed holes 81b.

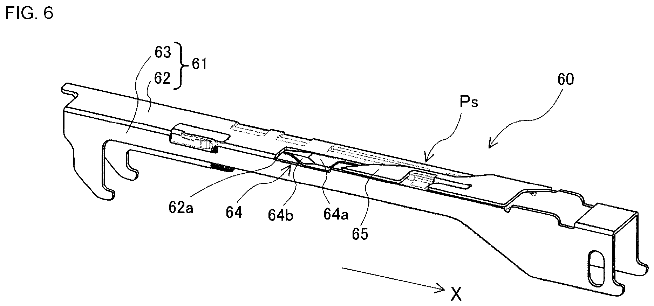

As illustrated in Fig. 6, tape guide 60 includes guide section 61. Guide section 61 guides carrier tape 80. Guide section 61 extends in the X-axis direction and is formed in a U-shaped cross section. Guide section 61 includes an upper wall portion 62 and a pair of side wall portions 63. Upper wall portion 62 has a function of regulating upward movement of carrier tape 80 to prevent carrier tape 80 from floating. Also, each of the pair of side wall portions 63 has a function of regulating movement of carrier tape 80 in a tape width direction.

Tape guide 60 includes component exposing section 64. Component exposing section 64 exposes component 3 in component housing section 81a of base tape 81. Component exposing section 64 exposes component 3 by peeling cover tape 82 from base tape 81 of carrier tape 80 immediately before component transfer position Ps.

Component exposing section 64 includes tongue portion 64a and blade portion 64b. Tongue portion 64a is inserted between base tape 81 and cover tape 82 during conveyance of carrier tape 80. Blade portion 64b is inserted into a bonding location between base tape 81 and cover tape 82 so as to partially peel cover tape 82 from base tape 81.

Opening 62a is provided in upper wall portion 62 of guide section 61 of tape guide 60. Opening 62a is formed by cutting a part of upper wall portion 62. Tongue portion 64a is disposed to be exposed to the outside through opening 62a. Tongue portion 64a is formed to extend in the X-axis direction. Tongue portion 64a is formed in a plate shape and disposed such that a plate surface is horizontal. Tongue portion 64a is fixed to guide section 61 at a downstream end portion in the X-axis direction by welding or the like. Tongue portion 64a is disposed such that a distal end portion thereof is directed toward an upstream side in the X-axis direction.

Tongue portion 64a has a predetermined width in a tape width direction of carrier tape 80. The predetermined width is set to be less than a tape width of carrier tape 80. Tongue portion 64a is disposed to be biased on one end portion side (specifically, on a side opposite to a side where feed holes 86 are provided) in the tape width direction among both end portions in the tape width direction where cover tape 82 is bonded to base tape 81 in the width direction of carrier tape 80. Tongue portion 64a is formed such that a distal end portion thereof has a mountain shape and is biased toward an end portion in tape width direction. Tongue portion 64a is disposed such that a distal end portion thereof is located directly above component housing section 81a of base tape 81.

Blade portion 64b is provided at a location biased in any one in the tape width direction among distal ends of tongue portion 64a. Blade portion 64b is provided to correspond to one end portion side (specifically, on a side opposite to a side where feed holes 81b are provided) in the tape width direction among both end portions in the tape width direction to which cover tape 82 is bonded to base tape 81 of carrier tape 80. Blade portion 64b is inserted between base tape 81 and cover tape 82 at one end portion of carrier tape 80 in the tape width direction, partially peels cover tape 82 from base tape 81, and exposes component 3 in component housing section 81a of base tape 81 at component transfer position Ps.

Tape guide 60 also includes folding section 65. After one end portion of cover tape 82 in the tape width direction is peeled off from base tape 81, folding section 65 raises and folds one end portion of cover tape 82 in the tape width direction on a peeling side. Folding section 65 is disposed on a downstream side of tongue portion 64a in a tape conveyance direction X and disposed on an upstream side of component transfer position Ps in the X-axis direction. Folding section 65 is formed in a plate shape and formed to increase in width from the upstream side in the X-axis direction to the downstream side in the X-axis direction. Folding section 65 is formed and disposed to close a part of opening 62a.

Control section 55 controls an operation of tape feeder 50. Specifically, control section 55 controls driving of motors 52c and 53c based on a detection result (specifically, presence or absence of carrier tape 80) of a sensor or the like disposed at each location of feeder main body 51 of tape feeder 50. Control section 55 includes a CPU and a memory and performs various types of processing according to a previously determined program.

Reel tag 90a indicating individual identification information for identifying reel 90 is attached to reel 90. Reel tag 90a is attached to reel 90 in a state of being printed on a seal. Reel tag 90a is given, for example, when a code (may be, for example, a model number of a component set by a manufacturer or the like, and hereinafter, referred to as a component code) of component 3 housed in carrier tape 80 wound around reel 90 is registered in association with reel 90. The individual identification information indicated by reel tag 90a is, for example, a one-dimensional code such as a barcode or a two-dimensional code. The individual identification information is information of each reel 90 and includes information on, for example, a type, a serial number, a manufacturer, and the like that are distinguished by a size, a reel width, and the like of reel 90.

Also, feeder tag 50a indicating individual identification information for identifying tape feeder 50 is attached to tape feeder 50. Feeder tag 50a is attached to tape feeder 50 in a state of being printed on a seal. The individual identification information indicated by feeder tag 50a is, for example, a one-dimensional code such as a barcode or a two-dimensional code. The individual identification information is information of each tape feeder 50 and includes, for example, a type, a serial number, a manufacturer, and the like that are distinguished by a size, a width, and the like of tape feeder 50.

Further, tape guide tag 60a indicating individual identification information for identifying tape feeder 50 is attached to tape guide 60. Tape guide tag 60a is attached to tape guide 60 in a state of being printed on a seal. The individual identification information indicated by tape guide tag 60a is, for example, a one-dimensional code such as a barcode or a two-dimensional code. The individual identification information is information of each tape guide 60 and includes, for example, a type, a serial number, a manufacturer, and the like that are distinguished by a size, a tape correspondence width, and the like of tape guide 60.

### 6. Configuration of Tag Reader

Tag reader 20 is a device for reading individual identification information from each of tags 50a, 60a, and 90a described above. Particularly, tag reader 20 can read the individual identification information from tape guide tag 60a. Tag reader 20 is installed in a factory or the like that performs an operation of attaching and detaching tape guide 60 to and from tape feeder 50. Tag reader 20 is a handy type reader that can be carried by an operator or is a reader attached to feeder main body 51 of tape feeder 50 or provided in a management warehouse for storing tape guide 60.

As illustrated in Fig. 1, tag reader 20 includes tag reading section 21, control section 22, display section 23, and communication section 24.

Tag reading section 21 reads a code such as a barcode or a two-dimensional code indicating individual identification information from tags 50a, 60a, and 90a. Tag reading section 21 is connected to control section 22. The code read by tag reading section 21 is supplied to control section 22.

Control section 22 performs various controls based on codes supplied from tag reading section 21. Control section 22 includes a CPU and a memory and performs various types of processing according to a previously determined program. Control section 22 is connected to communication section 24. Communication section 24 can communicate with host computer 30 by, for example, a wireless LAN or a wired LAN. When a code is supplied from tag reading section 21, control section 22 detects that the code is read, and causes communication section 24 to transmit the read code to host computer 30.

Control section 22 causes communication section 24 to transmit the code read particularly during a verification operation. It should be noted that the verification operation is an operation of continuously or individually reading each code of feeder tag 50a, tape guide tag 60a, and reel tag 90a and checking whether tape feeder 50, tape guide 60, and reel 90 are prepared in a correct correspondence relationship in, for example, component mounter 10.

The verification operation is performed, for example, in a state where tape guide 60 is mounted on tape feeder 50 and reel 90 for winding carrier tape 80 on tape feeder 50 is set, specifically, in a state where tape feeder 50 on which tape guide 60 is mounted is mounted in slot 12a of component mounter 10 and reel 90 for winding carrier tape 80 is held by reel holding section 14 of component mounter 10.

Display section 23 is a display device that can be visually recognized by an operator. Display section 23 is connected to control section 22. Display section 23 performs various types of screen displays according to an instruction from control section 22.

### 7. Configuration of Host Computer

Host computer 30 is a management device that can control component mounter 10 which is a management target and manage mounting members (specifically, tape feeder 50, tape guide 60, and reel 90) such as tape guide 60 mounted on component mounter 10. Host computer 30 includes a CPU, a memory, and a control circuit and performs various types of processing according to a previously determined program.

As illustrated in Fig. 1, host computer 30 includes control section 31, storage section 32, communication section 33, and display section 34. Control section 31 includes update section 31a, use control section 31b, first guide control section 31c, reading section 31d, limitable use section 31e, success/failure totalizing section 31f, and second guide control section 31g.

Storage section 32 stores, for example, a control program for controlling component mounter 10 or the like, job data D1 for manufacturing board 2, and management data D2 for managing component mounter 10, tape feeder 50, tape guide 60, and the like, and so on. Control section 31 can read a control program from storage section 32 and execute the program, control component mounter 10, and particularly, manage tape guide 60. Communication section 33 can communicate with communication section 24 of tag reader 20. Display section 34 is a display device that can be visually recognized by an operator. Display section 34 performs various types of screen displays according to an instruction from control section 31.

Job data D1 defines, for example, a production plan such as a position and an order of slots 12a in which there is component 3 to be mounted on board 2 by component mounter 10, and the number of produced boards 2, and the like. Host computer 30 transmits job data D1 to component mounter 10. Component mounter 10 sequentially mounts multiple components 3 on board 2 according to job data D1 from host computer 30.

Also, component mounter 10 can acquire component information such as a component code of component 3 that can be supplied, the greatest number of components 3 that can be supplied, and the number of components 3 that have been supplied (used), from tape feeder 50 mounted on slot 12a, and can transmit the component information to host computer 30 in association with a slot number of slot 12a and individual identification information of tape feeder 50 or reel 90. When receiving the component information from component mounter 10, host computer 30 associates the component information with the individual identification information of tape feeder 50 or reel 90 and stores the associated information in storage section 32.

Also, when an exposure process of component 3 is performed by component exposing section 64 of tape guide 60, component mounter 10 can acquire information indicating the fact that a component exposure process thereof has been performed and whether the component exposure process has succeeded or failed, from tape feeder 50 mounted on slot 12a, and can transmit the information to host computer 30 in association with the individual identification information of tape feeder 50 or tape guide 60. When receiving information from component mounter 10, host computer 30 causes update section 31a of control section 31 to perform update processing of information stored in storage section 32 based on the information, as described in detail below.

Host computer 30 can calculate a component run-out time when component run-out occurs in tape feeder 50 mounted on slot 12a or a reel 90 held by reel holding section 14. For example, host computer 30 calculates the above-described component run-out time based on the number of remained components 3, the number of components 3 used per board 2 to be produced, a production speed of board 2, a reduction rate of components 3, and the like.

Also, management data D2 includes, for example, data indicating whether tape feeder 50 is mounted on slot 12a of component mounter 10, data indicating whether reel 90 is disposed in reel holding section 14, and the like. Also, management data D2 may include data indicating a member type that can correspond to each mounting member of component mounter 10. For example, management data D2 may include data indicating a type of tape guide 60 that can be mounted on tape feeder 50 for each tape feeder 50 and a type of reel 90 that can correspond to tape feeder 50.

Host computer 30 associates a slot number of component mounter 10, individual identification information of tape feeder 50 mounted on slot 12a of component mounter 10, individual identification information of tape guide 60 mounted on tape feeder 50 thereof, individual identification information of reel 90 held in reel holding section 14 corresponding to tape feeder 50 thereof, and component information including a component code of component 3 housed in carrier tape 80 wound on reel 90 with each other and stores the same in storage section 32 as management data D2.

When receiving a code supplied from tag reader 20 by communication section 33, control section 31 of host computer 30 collates whether respective mounting members (specifically, tape feeder 50, tape guide 60, and reel 90) of component mounter 10 are appropriately mounted by using individual identification information indicated by the received code. Then, control section 31 notifies tag reader 20 of a collation result of the mounting member from which the individual identification information is read by tag reader 20.

When receiving the collation result, control section 22 of tag reader 20 causes display section 23 to display fact of normality and association of the respective mounting members in component mounter 10 when the collation result is normal, whereas causes display section 23 to display fact of a collation error and a mounting member erroneously mounted in component mounter 10 when the collation result is abnormal.

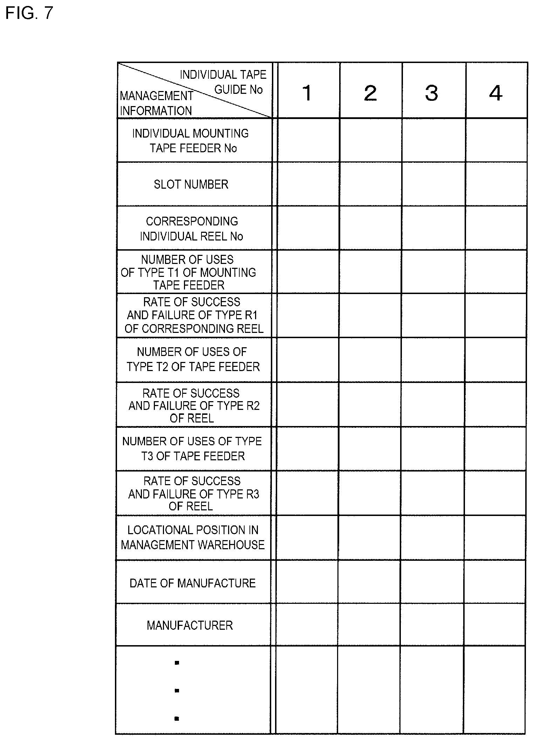

Also, as illustrated in Fig. 7, management data D2 particularly includes management information of tape guide 60 mounted on tape feeder 50. Management information of tape guide 60 includes at least data indicating a use history of tape guide 60 and location information of tape guide 60. Also, the management information may include information indicating a manufacturer of tape guide 60.

The use history includes the number of uses such as the number of mounting that tape guide 60 is mounted on tape feeder 50 and the number of exposure processes performed by component exposing section 64, and further includes rates of success and failure (for example, the number of successes and a success rate, or the number of failures and a failure rate) of the component exposure process for the number of exposure processes, and the like.

It should be noted that a use history may be a use history from start of use or end of inspection of tape guide 60. Also, when there are multiple tape feeders 50 on which tape guides 60 are mounted, the use history may be determined for each tape feeder 50 on which tape guide 60 is mounted. Alternatively, when there are multiple types of tape feeders 50 on which tape guides 60 are mounted, the use history may be determined for each type of tape feeder 50 on which tape guide 60 is mounted.

Also, the use history may include information on, for example, time of manufacture such as a date of manufacture of tape guide 60, a usable period after manufacture of tape guide 60 (for example, one year or three years), and the like. Also, the information in tape guide tag 60a may include information such as a reading date when individual identification information of tape guide 60 is read by tag reader 20, start time of use such as a date when tape guide 60 is usably taken out of an individually sealed bag or box, or a usable period from the start of use of tape guide 60. **It** should be noted that the usable period after manufacture or the usable period after start of use may be defined as a period during which it is expected that a component exposure process is not to be appropriately performed by tape guide 60 in a normal use environment.

Also, location information includes positions such as identification information and a position of component mounter 10 in which tape guide 60 is used in a factory, a storage position in which tape guide 60 is stored in a management warehouse, and a locational position a transporting vehicle on which tape guide 60 is transported.

### 8. Operation and Effect of Tape Guide Management System

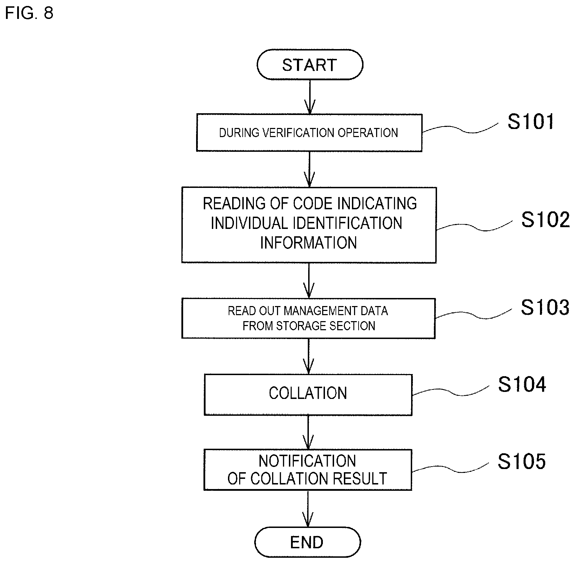

**In** tape guide management system 1, when a code indicating individual identification information is read by tag reader 20 from feeder tag 50a of tape feeder 50, tape guide tag 60a of tape guide 60, or reel tag 90a of reel 90 during a verification operation or the like (step S101 illustrated in Fig. 8), the read code is transmitted to host computer 30.

When control section 31 of host computer 30 receives the code from tag reader 20 (step S102), reading section 31d reads out management data D2 associated with individual identification information indicated by the code from storage section 32 (step S103), and use control section 31b collates a mounting member from which the individual identification information is read out according to read management data D2 (step S104). Then, control section 31 notifies tag reader 20 of the collation result through communication section 33 (step S105).

When receiving the collation result from host computer 30, control section 22 of tag reader 20 causes display section 23 to display fact of normality and further association of respective mounting members in component mounter 10 when the collation result is normal, whereas, when the collation result is abnormal, control section 22 of tag reader 20 causes display section 23 to display fact of a collation error and further the mounting member erroneously mounted in component mounter 10.

When the error display is made, an operator is prompted to exchange or repair the erroneously mounted mounting member, and thus, it is possible to handle a collation error. Therefore, the erroneously mounted mounting member can be prevented from maintaining in a state of being mounted on component mounter 10 by cooperation between tag reader 20 and host computer 30 described above.

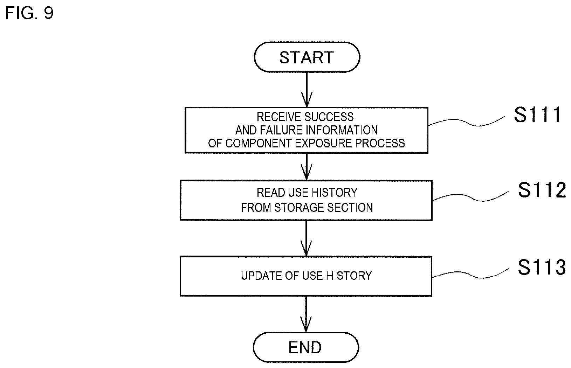

Also, when control section 31 of host computer 30 receives information transmitted from component mounter 10 side (specifically, tape feeder 50) indicating fact that the component exposure process has been performed by the component exposing section 64 and success or failure of the component exposure process (step S111 illustrated in Fig. 9), reading section 31d reads out a use history of the mounting member of component mounter 10 which is stored in storage section 32 as management data D2 (step S112), and update section 31a performs processing of updating the use history (step S113).

For example, update section 31a of control section 31 increments by "1" the number of component exposure processes by tape guide 60 which is stored in storage section 32, and, when the component exposure process fails and increments by "1" the number of failures of the component exposure process by tape guide 60 which is stored in storage section 32. Further, when the number of exposure processes or the number of failures is incremented, a failure rate of the component exposure process by tape guide 60 which is stored in storage section 32 is calculated. It should be noted that the failure rate is a ratio of the number of failures that the component exposure process fails among the number of exposure processes in which the component exposure process is performed by tape guide 60.

It should be noted that update of the above-described use history (particularly, the number of failures and the failure rate) may be performed only for tape feeder 50 on which tape guide 60 is mounted at the time of the update or for a type of tape feeder 50 and may be not performed for tape feeder 50 on which tape guide 60 is not mounted or for a type of tape feeder 50.

Storage section 32 of host computer 30 stores the lower limited number of limitable use for setting the use to be limited, the number of limitable use failures, or a limitable use failure rate as a limitable use threshold for each tape guide 60 or for each type of tape guide 60 and stores the number of guide sets set as the number of uses for guiding inspection time and exchange time of tape guide 60 to an operator. It should be noted that the number of guide sets is the number of lower limits where the component exposure process by tape guide 60 is contemplated not to be appropriately performed and is set to be less than the number of limitable use.

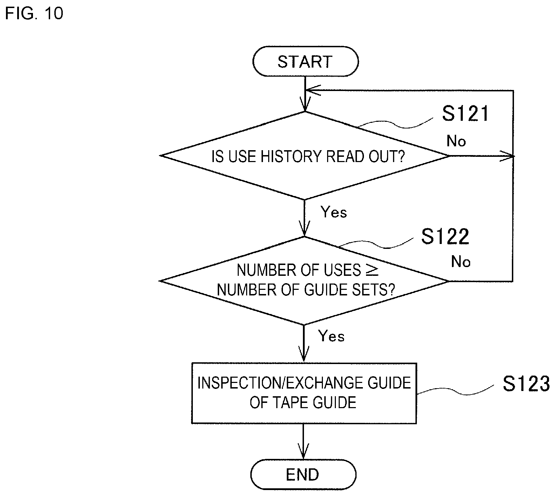

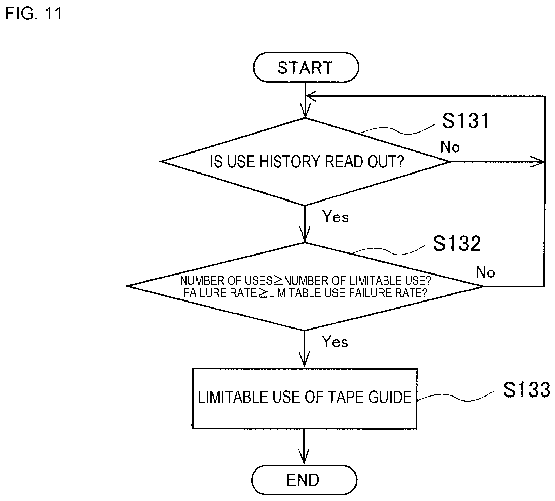

In control section 31, during the verification operation or the update processing, reading section 31d reads out a use history associated with individual identification information of corresponding tape guide 60 stored in storage section 32 (step S121 illustrated in Fig. 10 and step S131 illustrated in Fig. 11), and use control section 31b controls use of tape guide 60 based on the use history. Use control section 31b performs the use control for each tape guide 60.

Specifically, use control section 31b compares the number of uses by tape guide 60 and the number of guide sets to determine whether the number of uses is greater than or equal to the number of guide sets (step S122). Also, the number of uses is compared with the number of limitable use to determine whether the number of uses is greater than or equal to the number of limitable use, and the number of failures or a failure rate of a component exposure process by tape guide 60 is compared with the number of limitable use failures or a limitable use failure rate thereof to determine whether the number of failures is greater than or equal to the number of limitable use failures or whether the failure rate is greater than or equal to the limitable use failure rate (step S132). Then, use control section 31b controls use of tape guide 60 based on the determination result.

For example, when the number of uses of tape guide 60 is less than the number of guide sets, control section 31 does not perform guide processing of inspection and exchange on tape guide 60 for an operator. Meanwhile, when the number of uses of tape guide 60 is greater than or equal to the number of guide sets, first guide control section 31c performs guide processing of inspection and exchange on tape guide 60 for an operator (step S123).

The above-described guide processing is to perform display for notifying an operator that an inspection time of tape guide 60 arrives on, for example, a display device (not illustrated) provided in component mounter 10, display section 23 of tag reader 20, or display section 34 of host computer 30, and is to display an arrival itself and an arrival period.

According to the guide processing, an operator can be prompted to inspect or exchange tape guide 60 before a component exposure process by tape guide 60 is not appropriately performed for each tape guide 60. When an operator is prompted to inspect or exchange tape guide 60, the operator inspects or exchanges tape guide 60 mounted on tape feeder 50. Accordingly, tape guide 60 to be mounted on tape feeder 50 can be constantly maintained in an optimal state, and an appropriate component exposure process using tape guide 60 in component mounter 10 can be secured. Thereby, a component exposure process by tape guide 60 can be easily led to "success" and production efficiency can be prevented from reducing.

Also, when the number of uses of tape guide 60 is less than the number of limitable use, and when the number of failures or a failure rate of the component exposure process by tape guide 60 is less than the number of limitable use failures or a limitable use failure rate, control section 31 allows use of tape guide 60 without limitation. Meanwhile, when the number of uses of tape guide 60 is greater than or equal to the number of limitable use, or when the number of failures or the failure rate of the component exposure process by tape guide 60 is greater than or equal to the number of limitable use failures or the limitable use failure rate, limitable use section 31e limits the use of tape guide 60 (step S133).

The limitable use is, for example, to demand that component mounter 10 prohibits a component exposure process by tape guide 60, or to perform a display for prompting an operator not to perform the component exposure process by tape guide 60 in addition to or instead of the prohibition.

According to the limitable use, an operator can be prompted to limit use of, or further to limit the use of tape guide 60 in which the number of uses and a rateD of success and failure of a component exposure process do not satisfy a predetermined limitable use condition for each tape guide 60. When use of tape guide 60 is limited, an operator can inspect or exchange tape guide 60 mounted on tape feeder 50 and restart supply of component 3 by tape feeder 50. Accordingly, it is possible to exclude use of tape guide 60 that is unable to maintain an optimal state in performing the component exposure process, and to maintain an appropriate component exposure process using tape guide 60 in component mounter 10. Thereby, a component exposure process by tape guide 60 can be easily led to "success" and production efficiency can be prevented from reducing.

It should be noted that the limitable use of tape guide 60 described above may be only on tape feeder 50 that satisfies a limitable use condition (particularly, a condition on the number of failures and a failure rate) among all tape feeders 50 on which tape guide 60 can be mounted, or may be on a type of tape feeder 50 that satisfies the limitable use condition (particularly, the condition on the number of failures and the failure rate) among all types of tape feeders 50 on which tape guide 60 can be mounted.

As described above, if the limitable use of tape guide 60 is only for specific tape feeder 50, use of tape guide 60 for tape feeder 50 or a type thereof that does not satisfy the limitable use condition is allowed, and the use of tape guide 60 is continued although it is limited. Accordingly, it is possible to prevent tape guide 60 from being wastefully discarded, and to efficiently use tape guide 60, and to prevent an increase in the number of possessions (that is, the number of stocks) of tape guide 60 in consideration of the discardment of tape guide 60.

It should be noted that control section 31 may perform limitable use or use restart of tape guide 60 by performing a predetermined operation on an operation section provided in host computer 30 or the like by an operator when the exchange of tape guide 60 is started or completed.

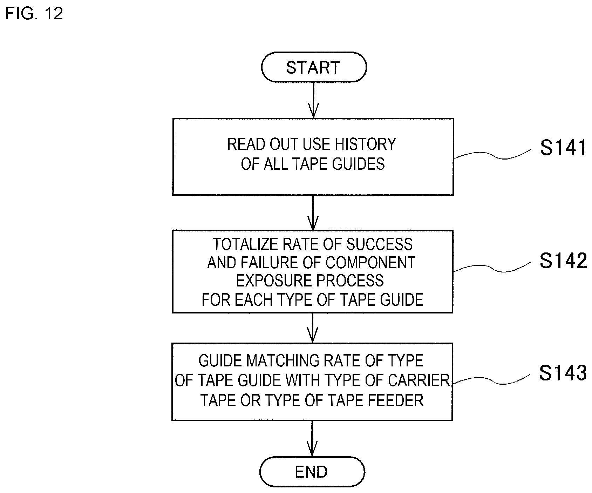

Also, in control section 31 of host computer 30, success/failure totalizing section 31f can totalize rates of success and failure of a component exposure process for each type of tape guide 60. Specifically, control section 31 first reads out a use history, which is stored in storage section 32 as management data D2, of all tape guides 60 associated with individual identification information of all tape guides 60 (step S141 illustrated in Fig. 12). Then, success/failure totalizing section 31f summarizes use history of each type of tape guide 60 and totalizes rates of success and failure of the component exposure process for each type of tape guide 60 (step S142).

The rate of success and failure is a ratio of the total number of successes that the component exposure process is successful to the total number of failures that the component exposure process fails among the total number of exposure processes obtained by totalizing the respective number of exposure processes of all tape guides 60 of the same type. The rate of success and failure is, for example, a total failure rate which is a ratio of the total number of failures obtained by totalizing the respective number of failures of tape guides 60 to the total number of exposure processes described above, or conversely, a total success rate which is a ratio of the total number of successes obtained by totalizing the respective number of successes of tape guides 60 thereto. Also, the rate of success and failure may be totalized by being divided into each type of carrier tape 80 for which tape feeder 50 has performed a component exposure process or each type of tape feeder 50 on which tape guide 60 is mounted.

When totalizing rates of success and failure of the component exposure process for each type of tape guide 60 as described above, control section 31 causes second guide control section 31g to provide a guide indicating a matching rate between a type of tape guide 60 and carrier tape 80 (particularly, the type) or tape feeder 50 (particularly, the type) to an operator, based on the totalization result (step S143). For example, second guide control section 31g causes display section 34 or the like to display the matching rate. When the processes are performed, display section 34 displays the matching rate between a type of tape guide 60 and carrier tape 80 or tape feeder 50.

**It** should be noted that the matching rate to be guided may be a total failure rate itself or a total success rate itself which is a totalization result or may display the total failure rate and the total success rate in, for example, four stages of "excellent", "good", "acceptable", and "unacceptable".

An operator can check carrier tape 80 or tape feeder 50 having good compatibility or conversely, poor compatibility for each type of tape guide 60 when viewing the matching rate guided as described above. In this case, the operator can exclude use of tape guide 60 that is incompatible with specific carrier tape 80 or tape feeder 50 and can use only tape guide 60 that is compatible with specific carrier tape 80 or tape feeder 50. Accordingly, in component mounter 10, tape guide 60 can be appropriately used to cause tape guide 60 mounted on tape feeder 50 to perform a component exposure process for carrier tape 80.

As described above, tape guide management system 1 manages tape guide 60 that is mounted on tape feeder 50 feeding carrier tape 80 having component 3 housed therein and can expose component 3 from carrier tape 80. Tape guide management system 1 includes tape guide tag 60a provided for each tape guide 60 and indicating individual identification information, tag reader 20 that reads out individual identification information from tape guide tag 60a, storage section 32 that stores the individual identification information and management information of tape guide 60 as management data D2 in association with each other, and host computer 30 that manages tape guide 60 based on management information corresponding to the individual identification information read by tag reader 20.

With the configuration, individual use of each tape guide 60 mounted on tape feeder 50 can be managed.

Also, in tape guide management system 1, the management information of tape guide 60 includes a use history of tape guide 60, and control section 31 of host computer 30 updates the use history corresponding to individual identification information of tape guide 60 stored in storage section 32 when a component exposure process of exposing component 3 from carrier tape 80 is performed by tape guide 60. With the configuration, use history of each tape guide 60 can be accumulated to correspond to individual identification information.

Also, in tape guide management system 1, the management information of tape guide 60 includes a use history of tape guide 60, and control section 31 of host computer 30 controls use of tape guide 60 based on the use history stored in storage section 32. With the configuration, tape guide 60 can be appropriately used according to use history thereof.

Also, in tape guide management system 1, control section 31 of host computer 30 performs guide for prompting an operator to inspect or exchange tape guide 60 based on a use history stored in storage section 32. With the configuration, an operator can be prompted to inspect or exchange tape guide 60 before a component exposure process is not appropriately performed for each tape guide, and thus, tape guide 60 to be mounted on tape feeder 50 can be constantly maintained in an optimal state.

Also, in tape guide management system 1, control section 31 of host computer 30 performs guide for prompting an operator to inspect or exchange tape guide 60 when the number of uses as a use history is greater than or equal to the number of guide sets, or performs guide for prompting the operator not to perform a component exposure process by tape guide 60 when the number of failures that the component exposure process as a use history fails is greater than or equal to the number of limitable use failures or a failure rate is greater than or equal to a limitable use failure rate. With the configuration, an operator can be prompted to inspect or exchange tape guide 60 before a component exposure process is not appropriately performed for each tape guide, and thus, tape guide 60 to be mounted on tape feeder 50 can be constantly maintained in an optimal state.

Also, in tape guide management system 1, a use history includes the number of exposure processes in which a component exposure process is performed and a rate of success and failure of the component exposure process. With the configuration, the number of exposure processes and a rate of success and failure thereof can be updated, or use of tape guide 60 can be controlled based on the number of exposure processes and the rate of success and failure thereof.

Also, in tape guide management system 1, control section 31 of host computer 30 reads out a rate of success and failure corresponding to individual identification information read by tag reader 20 from storage section 32, and limits use of tape guide 60 of the individual identification information when the number of failures that a component exposure process fails as the rate of success and failure or a failure rate is greater than or equal to the number of limitable use failures or a limitable use failure rate. With the configuration, use of tape guide 60 increased in the number of failures or a failure rate of a component exposure process is limited, and thus, the use of tape guide 60 that cannot maintain an optimal state in performing the component exposure process can be excluded, and an appropriate component exposure process using tape guide 60 in component mounter 10 can be maintained.

Also, in tape guide management system 1, a use history includes the number of exposure processes and a rate of success and failure for each type of carrier tape 80 on which tape guide 60 exposes component 3 or for each type of tape feeder 50 on which tape guide 60 is mounted. With the configuration, the number of exposure processes and a rate of success and failure of tape guide 60 for each type of carrier tape 80 or for each type of tape feeder 50 can be updated, or use of tape guide 60 can be controlled based on the number of exposure processes and the rate of success and failure.

Also, in tape guide management system 1, control section 31 of host computer 30 reads out a rate of success and failure corresponding to individual identification information read by tag reader 20 from storage section 32, and limits use of tape guide 60 of the individual identification information for a type of carrier tape or a type of tape feeder corresponding to the rate of success and failure when the number of failures that a component exposure process fails as the rate of success and failure or a failure rate is greater than or equal to the number of limitable use failures or a limitable use failure rate. With the configuration, use of tape guide 60 increased in the number of failures or a failure rate of a component exposure process for carrier tape 80 of a specific type or tape feeder 50 can be limited, and thus, the use of tape guide 60 that cannot maintain an optimal state in performing the component exposure process can be excluded, and an appropriate component exposure process using tape guide 60 in component mounter 10 can be maintained.

Also, in tape guide management system 1, control section 31 of host computer 30 totalizes rates of success and failure for each type of tape guide 60 and provides an operator with guide indicating a matching rate of a carrier tape or a tape feeder for each type of a tape guide based on the totalized rates of success and failure. With the configuration, carrier tape 80 or tape feeder 50 with good compatibility or conversely, poor compatibility for each type of tape guide 60 can be displayed to an operator, and thus, tape guide 60 can be appropriately used when tape guide 60 mounted on tape feeder 50 in component mounter 10 performs the component exposure process for carrier tape 80.

Also, in tape guide management system 1, a matching rate is a ratio between the number of successes that a component exposure process is successful and the number of failures that the component exposure process fails. With the configuration, a ratio between the number of successes that a component exposure process is successful by tape guide 60 and the number of failures that the component exposure process fails can be displayed to an operator.

Also, in tape guide management system 1, tape feeder 50 is an autoloading feeder including insertion section 51a into which a tape end of carrier tape 80 is inserted, and feeding sections 52 and 53 that feed carrier tape 80 in which a tape end is inserted into insertion section 51a to component transfer position Ps. With the configuration, individual management of tape guide 60 can be applied to an autoloading feeder in which a disposition positional relationship between tape feeder 50, tape guide 60, and reel 90 (or carrier tape 80) is severe.

Also, in tape guide management system 1, tag reader 20 is a handy type reader that can be carried by an operator or is a reader attached to feeder main body 51 of tape feeder 50 or provided in a management warehouse that stores tape guide 60. With the configuration, individual management of tape guide 60 can be performed in reading individual identification information of tape guide 60 at an appropriate location.

Also, in tape guide management system 1, reading of individual identification information from tape guide tag 60a by tag reader 20 is performed during a verification operation performed in a state where tape guide 60 is mounted on tape feeder 50 and reel 90 for winding carrier tape 80 on tape feeder 50 is set. With the configuration, management data D2 associated with individual identification information of tape guide 60 can be read during a verification operation.

Also, in tape guide management system 1, the management information of tape guide 60 includes a use history of tape guide 60, and control section 31 of host computer 30 reads out the use history stored in storage section 32 when tag reader 20 reads out individual identification information, and controls use of tape guide 60 based on the use history. With the configuration, tape guide 60 can be appropriately used according to a use history thereof read out from a storage section when individual identification information is read.

It should be noted that, in the embodiments described above, tape guide tag 60a corresponds to a "tag" described in the appended claims. Host computer 30 corresponds to a "management device" described in the appended claims. Control section 31 of host computer 30 corresponds to an "update section", a "use control section", a "first guide control section", a "reading section", a "limitable use section", a "success/failure totalizing section", and a "second guide control section" described in the appended claims.

### 9. Modification Embodiment

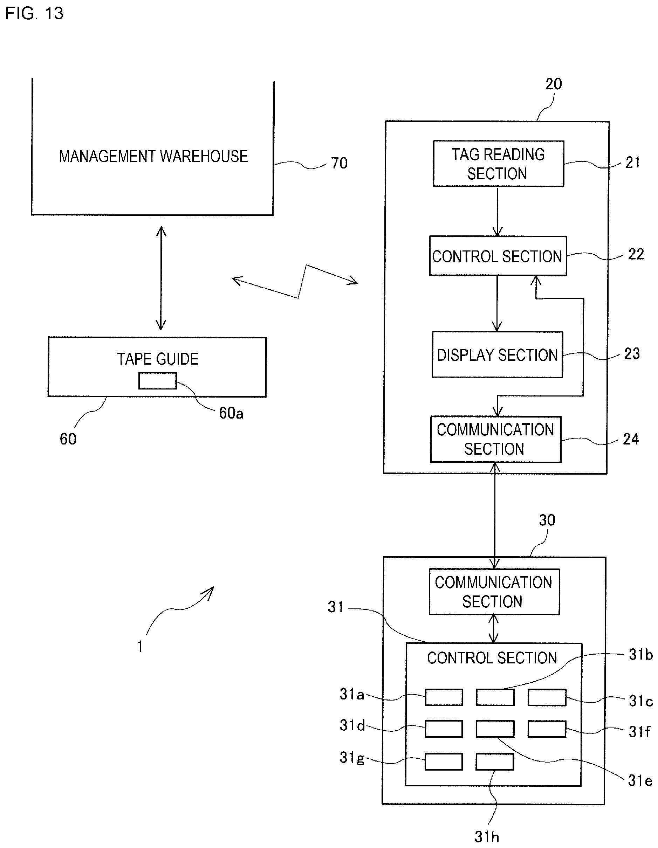

Incidentally, in the above-described embodiments, control section 31 of host computer 30 individually manages each tape guide 60 for use of tape guide 60 in component mounter 10. However, the present disclosure is not limited to this, and as illustrated in Fig. 13, when tape guide 60 is stored in management warehouse 70 including multiple storage shelves or is stored in any of multiple management warehouses 70, the present disclosure may be applied to management of stock and delivery in and from the management warehouse 70 for each tape guide 60.

For example, after tag reader 20 is disposed at a stock gate and a delivery gate of management warehouse 70, tag reader 20 may read individual identification information from tape guide tag 60a of tape guide 60 each time tape guide 60 is stocked and delivered, and control section 31 of host computer 30 may read out a locational position associated with the read individual identification information from storage section 32, and stock/delivery management section 31h of control section 31 may update the locational position.

According to the modification embodiment, information of a locational position storage section 32 can be updated according to stock and delivery of tape guide 60 in and from management warehouse 70, and stock and delivery of tape guide 60 in and from management warehouse 70 can be managed. Accordingly, the number of tape guides 60 held in management warehouse 70 can be easily checked, and thereby, the number of tape guides 60 held in a factory can be optimized. Also, if the locational position storage section 32 can be guided to an operator, an operator can easily confirm a locational position management warehouse 70 for each tape guide 60.

### Reference Signs List

1: Tape guide management system, 2: board, 3: component, 10: component mounter, 20: tag reader, 22: control section, 30: host computer (management device), 31: control section, 31a: update section, 31b: use control section, 31c: first guide control section, 31d: reading section, 31e: limitable use section, 31f: success/failure totalizing section, 31g: second guide control section, 32: storage section, 50: tape feeder, 50a: feeder tag, 60: tape guide, 60a: tape guide tag, 64: component exposing section, 70: management warehouse, 80: carrier tape, 90: reel, 90a: reel tag

## Claims

1. A tape guide management system (1) for managing a tape guide (60) that is mounted on a tape feeder (50) feeding a carrier tape (80) in which a component (3) is housed and is able to expose the component (3) from the carrier tape (80), the system (1) comprising:
a tag (60a) provided in each tape guide (60) and configured to indicate individual identification information;
a tag reader (20) configured to read the individual identification information from the tag (60a);
a storage section (32) configured to store the individual identification information and management information of the tape guide (60) in association with each other; and
a management device (30) configured to manage the tape guide (60) based on the management information corresponding to the individual identification information read by the tag reader (20), wherein
a use history includes the number of exposure processes that an exposure process of exposing the component (3) from the carrier tape (80) is performed by the tape guide (60), and a rate of success and failure of the exposure process,
**characterized in that:**
the management device (30) includes
a success/failure totalizing section (31f) configured to totalize the rate of success and failure for each type of the tape guide (60), and
a second guide control section (31g) configured to perform a second guide indicating a matching rate of the carrier tape (80) or the tape feeder (50) for each type of the tape guide (60) to an operator based on the rate of success and failure totalized by the success/failure totalizing section (31f).

2. The tape guide management system (1) according to claim 1, wherein the management information includes the use history of the tape guide (60), and
the management device (30) includes an update section (31a) configured to update the use history corresponding to the individual identification information of the tape guide (60) stored in the storage section (32) when the exposure process of exposing the component (3) from the carrier tape (80) is performed by the tape guide (60).

3. The tape guide management system (1) according to claim 1 or 2, wherein the management information includes the use history of the tape guide (60), and
the management device (30) includes a use control section (31b) configured to control use of the tape guide (60) based on the use history stored in the storage section (32).

4. The tape guide management system (1) according to claim 2 or 3, wherein the management device (30) includes a first guide control section (31c) configured to perform a first guide for prompting an operator to inspect or exchange the tape guide (60) based on the use history stored in the storage section (32).

5. The tape guide management system (1) according to claim 4, wherein, when the number of exposure processes that the exposure process of exposing the component (3) from the carrier tape (80) is performed by the tape guide (60) as the use history, the number of failures that the exposure process fails, or a failure rate is greater than or equal to a first threshold, the first guide control section (31c) performs the first guide for the operator.

6. The tape guide management system (1) according to claim 1, wherein the management device (30) includes
a reading section (31d) configured to read out the rate of success and failure corresponding to the individual identification information read by the tag reader (20) from the storage section (32), and
a limitable use section (31e) configured to limit use of the tape guide (60) of the individual identification information when the number of failures that the exposure process fails as the rate of success and failure read out by the reading section (31d) or a failure rate is greater than or equal to a second threshold.

7. The tape guide management system (1) according to claim 1, wherein the use history includes the number of exposure processes and the rate of success and failure for each type of the carrier tape (80) on which the tape guide (60) exposes the component (3) or for each type of the tape feeder (50) on which the tape guide (60) is mounted.

8. The tape guide management system (1) according to claim 7, wherein the management device (30) includes
a reading section (31d) configured to read out the rate of success and failure corresponding to the individual identification information read by the tag reader (20) from the storage section (32), and
a limitable use section (31e) configured to limit use of the tape guide (60) of the individual identification information on the type of the carrier tape (80) or the type of the tape feeder (50) corresponding to the rate of success and failure when the number of failures that the exposure process fails as the rate of success and failure read out by the reading section (31d) or a failure rate is greater than or equal to a third threshold.

9. The tape guide management system (1) according to claim 1, wherein the matching rate is a ratio of the number of successes that the exposure process is successful and the number of failures that the exposure process fails.

10. The tape guide management system (1) according to any one of claims 1 to 9, wherein the tape feeder (50) is an autoloading feeder including an insertion section into which a tape end of the carrier tape (80) is inserted, and a feeding section configured to feed the carrier tape (80) in which the tape end is inserted into the insertion section.

11. The tape guide management system (1) according to any one of claims 1 to 10, wherein the tag reader (20) is a handy type reader that is able to be carried by an operator, or is a reader attached to a feeder main body of the tape feeder (50) or provided in a management warehouse (70) that stores the tape guide (60).

12. The tape guide management system (1) according to any one of claims 1 to 11, further comprising:
the management warehouse (70) configured to store the tape guide (60), wherein the management information includes location information of the tape guide (60), and
the management device (30) includes a stock/delivery management section configured to manage stock and delivery of the tape guide (60) in and from the management warehouse (70) based on the management information corresponding to the individual identification information read by the tag reader (20).

13. The tape guide management system (1) according to any one of claims 1 to 12, wherein reading of the individual identification information from the tag (60a) by the tag reader (20) is performed during a verification operation performed in a state where the tape guide (60) is mounted on the tape feeder (50) and a reel (90) for winding the carrier tape (80) on the tape feeder (50) is set.

14. The tape guide management system (1) according to claim 13, wherein the management information includes the use history of the tape guide (60), and
the management device (30) reads out the use history stored in the storage section (32) when reading of the individual identification information by the tag reader (20) is performed, and controls use of the tape guide (60) based on the use history.

## Patentansprüche

1. Ein Bandführungsverwaltungssystem (1) zum Verwalten einer Bandführung (60), die an einem Bandzuführer (50) angebracht ist, der ein Trägerband (80) zuführt, in dem ein Bauteil (3) untergebracht ist, und die in der Lage ist, das Bauteil (3) aus dem Trägerband (80) freizulegen, wobei das System (1) umfasst:
ein Etikett (60a), das in jeder Bandführung (60) angeordnet und konfiguriert ist, individuelle Identifikationsinformationen anzuzeigen;
einen Etiketten-Leser (20), der konfiguriert ist, die individuellen Identifikationsinformationen von dem Etikett (60a) zu lesen;
einen Speicherabschnitt (32), der konfiguriert ist, die individuellen Identifikationsinformationen und Verwaltungsinformationen der Bandführung (60) in Zuordnung zueinander zu speichern; und
eine Verwaltungsvorrichtung (30), die konfiguriert ist, die Bandführung (60) auf der Grundlage der Verwaltungsinformationen zu verwalten, die den vom Etiketten-Leser (20) gelesenen individuellen Identifikationsinformationen entsprechen, wobei
eine Nutzungshistorie die Anzahl der Belichtungsprozesse, bei denen ein Belichtungsprozess zum Belichten des Bauteils (3) vom Trägerband (80) durch die Bandführung (60) durchgeführt wird, sowie eine Erfolgs- und Fehlerquote des Belichtungsprozesses umfasst,
**dadurch gekennzeichnet, dass:**
die Verwaltungsvorrichtung (30) umfasst
einen Erfolgs-/Fehlersummierungsabschnitt (31f), der konfiguriert ist, die Erfolgs- und Fehlerquote für jeden Typ der Bandführung (60) zu summieren, und
einen zweiten Führungssteuerabschnitt (31g), der konfiguriert ist, für jeden Typ der Bandführung (60) auf der Grundlage der vom Erfolgs-/Fehlersummierungsabschnitt (31f) summierten Erfolgs- und Fehlerrate eine zweite Führung durchzuführen, die einem Bediener eine Übereinstimmungsrate des Trägerbands (80) oder des Bandzuführers (50) anzeigt.

2. Das Bandführungsverwaltungssystem (1) gemäß Anspruch 1, wobei die Verwaltungsinformationen die Nutzungshistorie der Bandführung (60) umfassen, und
die Verwaltungsvorrichtung (30) einen Aktualisierungsabschnitt (31a) umfasst, der konfiguriert ist, die Nutzungshistorie entsprechend den individuellen Identifikationsinformationen der Bandführung (60), die in dem Speicherabschnitt (32) gespeichert sind, zu aktualisieren, wenn der Belichtungsprozess zum Belichten des Bauteils (3) vom Trägerband (80) durch die Bandführung (60) durchgeführt wird.

3. Das Bandführungsverwaltungssystem (1) gemäß Anspruch 1 oder 2, wobei die Verwaltungsinformationen die Nutzungshistorie der Bandführung (60) umfassen, und
die Verwaltungsvorrichtung (30) einen Nutzungssteuerabschnitt (31b) umfasst, der konfiguriert ist, die Nutzung der Bandführung (60) auf der Grundlage der im Speicherabschnitt (32) gespeicherten Nutzungshistorie zu steuern.

4. Das Bandführungsverwaltungssystem (1) gemäß Anspruch 2 oder 3, wobei
die Verwaltungsvorrichtung (30) einen ersten Führungssteuerabschnitt (31c) umfasst, der konfiguriert ist, eine erste Führung durchzuführen, um einen Bediener aufzufordern, die Bandführung (60) auf der Grundlage der im Speicherabschnitt (32) gespeicherten Nutzungshistorie zu überprüfen oder auszutauschen.

5. Das Bandführungsverwaltungssystem (1) gemäß Anspruch 4, wobei,
wenn die Anzahl der Belichtungsprozesse, bei denen der Belichtungsprozess zum Belichten des Bauteils (3) vom Trägerband (80) durch die Bandführung (60) durchgeführt wird, als Nutzungshistorie die Anzahl der Ausfälle, bei denen der Belichtungsprozess fehlschlägt, oder eine Ausfallrate größer oder gleich einem ersten Schwellenwert ist, der erste Führungssteuerabschnitt (31c) die erste Führung für den Bediener durchführt.

6. Das Bandführungsverwaltungssystem (1) gemäß Anspruch 1, wobei die Verwaltungsvorrichtung (30) umfasst
einen Leseabschnitt (31d), der konfiguriert ist, die Erfolgs- und Fehlerrate entsprechend den individuellen Identifikationsinformationen, die vom Etiketten-Leser (20) gelesen wurden, aus dem Speicherbereich (32) auszulesen, und
einen Nutzungsbegrenzungsabschnitt (31e), der konfiguriert ist, die Nutzung der Bandführung (60) der individuellen Identifikationsinformationen zu begrenzen, wenn die Anzahl der Fehlschläge, bei denen der Belichtungsprozess scheitert, als die vom Leseabschnitt (31d) ausgelesene Erfolgs- und Fehlerrate oder als Fehlerquote größer oder gleich einem zweiten Schwellenwert ist.

7. Das Bandführungsverwaltungssystem (1) gemäß Anspruch 1, wobei
die Nutzungshistorie die Anzahl der Belichtungsprozesse und die Erfolgs- und Fehlerrate für jeden Typ des Trägerbands (80), auf dem die Bandführung (60) das Bauteil (3) belichtet, oder für jeden Typ des Bandzuführers (50), auf dem die Bandführung (60) montiert ist, umfasst.

8. Das Bandführungsverwaltungssystem (1) gemäß Anspruch 7, wobei die Verwaltungsvorrichtung (30) umfasst
einen Leseabschnitt (31d), der konfiguriert ist, die Erfolgs- und Fehlerrate entsprechend den individuellen Identifikationsinformationen, die vom Etiketten-Leser (20) gelesen wurden, aus dem Speicherbereich (32) auszulesen, und
einen Nutzungsbegrenzungsabschnitt (31e), der konfiguriert ist, die Nutzung der Bandführung (60) der individuellen Identifikationsinformationen für den Typ des Trägerbands (80) oder den Typ des Bandzuführers (50) entsprechend der Erfolgs- und Fehlerrate zu begrenzen, wenn die Anzahl der Fehler, bei denen der Belichtungsprozess fehlschlägt, als die vom Leseabschnitt (31d) ausgelesene Erfolgs- und Fehlerrate oder eine Fehlerrate größer oder gleich einem dritten Schwellenwert ist.

9. Das Bandführungsverwaltungssystem (1) gemäß Anspruch 1, wobei
die Übereinstimmungsrate das Verhältnis zwischen der Anzahl der erfolgreichen Belichtungsvorgänge und der Anzahl der fehlgeschlagenen Belichtungsvorgänge ist.

10. Das Bandführungsverwaltungssystem (1) gemäß einem der Ansprüche 1 bis 9, wobei
der Bandzuführer (50) ein automatischer Zuführer ist, der einen Einführabschnitt, in den ein Bandende des Trägerbands (80) eingeführt wird, und einen Zuführabschnitt umfasst, der konfiguriert ist, das Trägerband (80), dessen Bandende in den Einführabschnitt eingeführt ist, zuzuführen.

11. Das Bandführungsverwaltungssystem (1) gemäß einem der Ansprüche 1 bis 10, wobei
der Etiketten-Leser (20) ein handlicher Leser ist, der von einem Bediener getragen werden kann, oder ein Leser ist, der an einem Zuführerhauptkörper des Bandzuführers (50) angebracht oder in einem Verwaltungslager (70) angeordnet ist, das die Bandführung (60) lagert.

12. Das Bandführungsverwaltungssystem (1) gemäß einem der Ansprüche 1 bis 11, das ferner umfasst:
das Verwaltungslager (70), das konfiguriert ist die Bandführung (60) zu lagern, wobei die Verwaltungsinformationen Standortinformationen der Bandführung (60) umfassen, und
die Verwaltungsvorrichtung (30) einen Bestands-/Lieferverwaltungsabschnitt umfasst, der konfiguriert ist, den Bestand und die Lieferung der Bandführung (60) in das und aus dem Verwaltungslager (70) auf der Grundlage der Verwaltungsinformationen zu verwalten, die den vom Etiketten-Leser (20) gelesenen individuellen Identifikationsinformationen entsprechen.

13. Das Bandführungsverwaltungssystem (1) gemäß einem der Ansprüche 1 bis 12, wobei
das Lesen der individuellen Identifikationsinformationen von dem Etikett (60a) durch den Etiketten-Leser (20) während eines Verifizierungsvorgangs erfolgt, der in einem Zustand durchgeführt wird, in dem die Bandführung (60) an dem Bandzuführer (50) angebracht ist und eine Spule (90) zum Aufwickeln des Trägerbands (80) auf dem Bandzuführer (50) eingesetzt ist.

14. Das Bandführungsverwaltungssystem (1) gemäß Anspruch 13, wobei die Verwaltungsinformationen die Nutzungshistorie der Bandführung (60) umfassen und
die Verwaltungsvorrichtung (30) die im Speicherabschnitt (32) gespeicherte Nutzungshistorie ausliest, wenn das Auslesen der individuellen Identifikationsinformationen durch den Etiketten-Leser (20) durchgeführt wird, und die Nutzung der Bandführung (60) auf der Grundlage der Nutzungshistorie steuert.

## Revendications

1. Système de gestion de guide de bande (1) pour gérer un guide de bande (60) qui est monté sur un dispositif d'alimentation de bande (50) alimentant une bande porteuse (80) dans laquelle est logé un composant (3) et est apte à exposer le composant (3) à partir de la bande porteuse (80), le système (1) comprenant :
une étiquette (60a) prévue dans chaque guide de bande (60) et configurée pour indiquer des informations d'identification individuelles ;
un lecteur d'étiquette (20) configuré pour lire les informations d'identification individuelles à partir de l'étiquette (60a) ;
une section de stockage (32) configurée pour stocker les informations d'identification individuelles et des informations de gestion du guide de bande (60) en association les unes avec les autres ; et
un dispositif de gestion (30) configuré pour gérer le guide de bande (60) sur la base des informations de gestion correspondant aux informations d'identification individuelles lues par le lecteur d'étiquette (20), dans lequel
un historique d'utilisation comprend le nombre de processus d'exposition où un processus d'exposition consistant à exposer le composant (3) à partir de la bande porteuse (80) est réalisé par le guide de bande (60), et un taux de réussite et d'échec du processus d'exposition,
**caractérisé en ce que :**
le dispositif de gestion (30) comprend
une section de totalisation des succès/échecs (31f) configurée pour totaliser le taux de réussite et d'échec pour chaque type du guide de bande (60), et
une seconde section de commande de guidage (31g) configurée pour réaliser un second guidage indiquant à un opérateur un taux de correspondance de la bande porteuse (80) ou du dispositif d'alimentation de bande (50) pour chaque type de guide de bande (60), sur la base du taux de réussite et d'échec totalisé par la section de totalisation des succès/échecs (31f).

2. Système de gestion de guide de bande (1) selon la revendication 1, dans lequel les informations de gestion comprennent l'historique d'utilisation du guide de bande (60), et
le dispositif de gestion (30) comprend une section de mise à jour (31a) configurée pour mettre à jour l'historique d'utilisation correspondant aux informations d'identification individuelles du guide de bande (60) stockées dans la section de stockage (32) lorsque le processus d'exposition consistant à exposer le composant (3) à partir de la bande porteuse (80) est réalisé par le guide de bande (60).

3. Système de gestion de guide de bande (1) selon la revendication 1 ou 2, dans lequel les informations de gestion comprennent l'historique d'utilisation du guide de bande (60), et
le dispositif de gestion (30) comprend une section de commande d'utilisation (31b) configurée pour commander l'utilisation du guide de bande (60) sur la base de l'historique d'utilisation stocké dans la section de stockage (32).

4. Système de gestion de guide de bande (1) selon la revendication 2 ou 3, dans lequel le dispositif de gestion (30) comprend une première section de commande de guidage (31c) configurée pour réaliser un premier guidage afin d'inciter un opérateur à inspecter ou échanger le guide de bande (60) sur la base de l'historique d'utilisation stocké dans la section de stockage (32).

5. Système de gestion de guide de bande (1) selon la revendication 4, dans lequel, lorsque le nombre de processus d'exposition où le processus d'exposition consistant à exposer le composant (3) à partir de la bande porteuse (80) est réalisé par le guide de bande (60) comme étant l'historique d'utilisation, le nombre d'échecs où le processus d'exposition échoue, ou un taux d'échec, est supérieur ou égal à un premier seuil, la première section de commande de guidage (31c) réalise le premier guidage pour l'opérateur.

6. Système de gestion de guide de bande (1) selon la revendication 1, dans lequel le dispositif de gestion (30) comprend
une section de lecture (31d) configurée pour lire, à partir de la section de stockage (32), le taux de réussite et d'échec correspondant aux informations d'identification individuelles lues par le lecteur d'étiquette (20), et
une section de limitation d'utilisation (31e) configurée pour limiter l'utilisation du guide de bande (60) des informations d'identification individuelles lorsque le nombre d'échecs où le processus d'exposition échoue, comme étant le taux de réussite et d'échec lu par la section de lecture (31d), ou un taux d'échec, est supérieur ou égal à un deuxième seuil.

7. Système de gestion de guide de bande (1) selon la revendication 1, dans lequel l'historique d'utilisation comprend le nombre de processus d'exposition et le taux de réussite et d'échec pour chaque type de la bande porteuse (80) sur laquelle le guide de bande (60) expose le composant (3), ou pour chaque type du dispositif d'alimentation de bande (50) sur lequel le guide de bande (60) est monté.

8. Système de gestion de guide de bande (1) selon la revendication 7, dans lequel le dispositif de gestion (30) comprend
une section de lecture (31d) configurée pour lire, à partir de la section de stockage (32), le taux de réussite et d'échec correspondant aux informations d'identification individuelles lues par le lecteur d'étiquette (20), et
une section de limitation d'utilisation (31e) configurée pour limiter l'utilisation du guide de bande (60) des informations d'identification individuelles sur le type de la bande porteuse (80) ou le type du dispositif d'alimentation de bande (50) correspondant au taux de réussite et d'échec, lorsque le nombre d'échecs où le processus d'exposition échoue, comme étant le taux de réussite et d'échec lu par la section de lecture (31d), ou un taux d'échec, est supérieur ou égal à un troisième seuil.

9. Système de gestion de guide de bande (1) selon la revendication 1, dans lequel le taux de correspondance est un rapport entre le nombre de réussites où le processus d'exposition est réussi et le nombre d'échecs où le processus d'exposition échoue.

10. Système de gestion de guide de bande (1) selon l'une quelconque des revendications 1 à 9, dans lequel le dispositif d'alimentation de bande (50) est un dispositif d'alimentation à chargement automatique comprenant une section d'insertion dans laquelle est insérée une extrémité de bande de la bande porteuse (80), et une section d'alimentation configurée pour alimenter la bande porteuse (80) dans laquelle l'extrémité de bande est insérée dans la section d'insertion.

11. Système de gestion de guide de bande (1) selon l'une quelconque des revendications 1 à 10, dans lequel le lecteur d'étiquette (20) est un lecteur de type portable qui peut être transporté par un opérateur, ou un lecteur fixé au corps principal du dispositif d'alimentation de bande (50), ou prévu dans un entrepôt de gestion (70) qui stocke le guide de bande (60).

12. Système de gestion de guide de bande (1) selon l'une quelconque des revendications 1 à 11, comprenant en outre :
l'entrepôt de gestion (70) configuré pour stocker le guide de bande (60), dans lequel les informations de gestion comprennent des informations de localisation du guide de bande (60), et
le dispositif de gestion (30) comprend une section de gestion des stocks/distributions configurée pour gérer les stocks et les distributions du guide de bande (60) vers et depuis l'entrepôt de gestion (70), sur la base des informations de gestion correspondant aux informations d'identification individuelles lues par le lecteur d'étiquette (20).

13. Système de gestion de guide de bande (1) selon l'une quelconque des revendications 1 à 12, dans lequel la lecture des informations d'identification individuelles à partir de l'étiquette (60a) par le lecteur d'étiquette (20) est réalisée lors d'une opération de vérification réalisée dans un état dans lequel le guide de bande (60) est monté sur le dispositif d'alimentation de bande (50) et une bobine (90) pour enrouler la bande porteuse (80) sur le dispositif d'alimentation de bande (50) est placée.

14. Système de gestion de guide de bande (1) selon la revendication 13, dans lequel les informations de gestion comprennent l'historique d'utilisation du guide de bande (60), et
le dispositif de gestion (30) lit l'historique d'utilisation stocké dans la section de stockage (32) lorsque la lecture des informations d'identification individuelles par le lecteur d'étiquette (20) est réalisée, et commande l'utilisation du guide de bande (60) sur la base de l'historique d'utilisation.
